# EUROPEAN PATENT SPECIFICATION

(11) **EP 1 832 933 B1**
(45) Date of publication and mention of the grant of the patent: **01.10.2008**
(21) Application number: 06004734.7
(22) Date of filing: 08.03.2006
(51) Int. Cl.: G03F 9/00, G03F 7/20

(54) **Device manufacturing method and substrate processing apparatus, and substrate support structure**
Verfahren zur Herstellung eines Bauelements und Apparat zur Prozessierung eines Substrats, sowie Substratträger
Procédé de fabrication d'un dispositif et appareil de traitement d'un substrat, et support de substrat

(43) Date of publication of application: 12.09.2007
(73) Proprietor: Thallner, Erich, 4780 Schärding (AT)
(72) Inventor: Thallner, Erich, 4780 Schärding (AT)
(74) Representative: Zinkler, Franz

(56) References cited:
- EP-A- 1 617 293
- US-A- 4 861 162
- US-A1- 2002 127 865
- US-B1- 6 208 407
- PATENT ABSTRACTS OF JAPAN vol. 014, no. 248 (E-0933), 28 May 1990 (1990-05-28) & JP 02 069958 A (NEC CORP), 8 March 1990 (1990-03-08)
- PATENT ABSTRACTS OF JAPAN vol. 2003, no. 12, 5 December 2003 (2003-12-05) & JP 2005 317653 A (NIPPON MINI COMPUTER SYSTEM KK), 10 November 2005 (2005-11-10)

## Description

The present invention relates to the processing of substrates and in particular to a concept for precise and efficient alignment of substrates with respect to processing units.

Continuing progress in the semiconductor industry is leading to ever-smaller structures that have to be processed on the surface of a substrate, such as a silicon wafer. Presently, structures that are to be processed on the surface of a wafer are transferred to the wafer by photolithographic methods, i.e. by projecting the structures through a mask on the wafer surface. This is normally done using ultra-violet light that allows, due to its short wave length, the generation of small structures and can at the same time be used to activate material, such as photo resistive coatings of the wafer. The desire to further decrease size of the semiconductor structures thus leads to the problem of projecting structures of the size of hundreds of nanometers or possibly even of tens of nanometers to the wafer surface. The transfer of the desired structure from the mask to the surface of the wafer was continuously developed and an on-going decrease of structure size was accomplished in the past using different physical effects, such as decreasing the structure size using media of high refraction index in between the mask and the wafer. Nonetheless, the limit of the optical transfer processes seems to be nearly reached.

Several different approaches to further decrease the structure size in the future are discussed. Particularly attractive are so-called nano-imprinting techniques that achieve the application of the structures on the wafer surface by a printing technique, comparable to a normal stamp. On the one hand, stamps of solid material, typically of metal such as nickel, can be applied to mechanically imprint a structure on the surface. On the other hand, one may use stamps of soft materials, such as PDMS (Polydimethylsiloxan), that can transfer Thiole to the surface of the wafer, which may prevent the surface from chemical etching. Using nano-imprinting techniques, structure sizes can easily go down to the nanometer scale, i.e. transistors with gate lengths in the 10 nm-regime become feasible.

Typically, the production of a semiconductor device comprises several consecutive steps of different processes, such as etching or photolithography, wherein each of the steps has to be precisely aligned with the preceding step to produce a functional semiconductor device. It may be noted that also the production of microscopic mechanical elements on substrates is a field of high commercial interest and shares the same demands on high alignment precision of consecutive production steps. It is evident that a transition to future structures, for example, by nano-imprinting, will further increase the accuracy demands of the alignment processes.

During the processing of a semiconductor device alignment of the semiconductor with respect to processing devices is normally required several times during the production. This is typically done using marks which are imprinted on the surface of the wafer. A typical computer processor has only an active area of several hundreds of mm², whereas a wafer may be as big as 30cm in diameter. That is only a small fraction of the wafer size is processed in a single photolithographic step and thus the complete wafer is processed by a sequence of consecutive photolithographic steps across the wafer surface. Once the complete wafer surface is processed, one proceeds to a next production step, transferring more structures on the wafer. That is, each wafer segment or process area (corresponding to the size of a single photolithographic step) has to be aligned with the processing unit in the next step of the process for guaranteeing a fully functional device.

This is normally done by marks surrounding the individual process areas and that allow for an adjustment of the process unit with respect to the process area before processing the wafer. Normally, the marks are detected and adjusted by optical methods that provide sufficient accuracy for the optical processing techniques currently available. For further proceeding technology, i.e. decreasing the structure sizes into the nanometer regime, the precision of these alignment procedures is insufficient.

One further problem of the marks surrounding the process areas is that these marks have to be transferred or refreshed after each single production step, since the marks themselves may be erased or falsified by certain process steps, such as sputtering or etching. Therefore, the marks themselves have to be transferred to each consecutive production step, which may yield accumulating errors during the production, decreasing the efficiency of correctly manufactured semiconductor devices on the wafer. Apart from these principle problems of the prior art, there are also technical problems, such as the space that is required for the prior art optical alignment systems. When using nano-imprinting methods for the production the very first production step can principally be performed without alignment. However, when it comes to consecutive production steps, alignment is still required even with higher accuracy, when using the nano-imprinting technique with its structure sizes in the nm-regime.

The space-problems (related to the space required for alignment systems close to the process units) tend to increase when going to nanometer-scales, since then, systems that are able to adjust on a nanometer scale are rather big (compared to the size of the device that has to be structured). In the case of nano-imprinting, an alignment system operating on a nanometer scale that is incorporated into the processing unit (stamp) is presently not feasible. An atomic force microscope is a high precision measurement tool, that is probing the surface of a material by a mechanical probe which has a tip of the size of essentially one atomic diameter (in the order of 10⁻¹⁰ m). Although the tip itself and the needle having this tip, is normally rather small, the read-out is performed with an optical laser system that detects the tip movement by a change of the position of a reflected laser spot on an imaging device. To detect movements of several nanometers, the dimensions of the read-out system have to be rather big, thus making it infeasible to incorporate them into the process unit that stamps the surface of a wafer.

One further big disadvantage of the prior art method is that the alignment (adjustment) of the process unit with respect to the wafer and the processing itself is done in a sequential manner, i.e. one alignment step is preceding each processing step, which is putting limits to the overall efficiency of a production process using prior art alignment.

This is especially true when either the processing or the adjustment is consuming much more time than its counterpart, which means that in the view of overall processing time for a single wafer, a lot of time is wasted awaiting the end of one particular process step.

Some approaches are known in the art as to how to increase efficency of wafer handling. For example, US 4,861,162 relates to the alignment of an object, and in particular, to the alignment of dyes on a wafer with the exposure area of a projection apparatus. To sequentially position different regions of a semiconductor wafer in a processing station, the detection of those positions at a pre-processing station is proposed. Therefore, at the pre-processing station, positions of the different regions of the wafer with respect to a reference mark are detected, wherein the reference mark is an optical mark, which is placed on a wafer chuck. At the processing station, the position of the reference mark is detected with respect to a standard mark. Based on the detection of the position of the reference marks with respect to same standard mark, the detection of the position of the different regions of the wafer is performed with respect to the standard marks such that the wafer can be sequentially moved within the transfer station, to propagate the different regions of the wafer to the exposure area.

US 6,208,407 B1 relates to an apparatus for repetitively projecting a mask pattern on a substrate, using a timesaving height measurement. In a measuring process, a substrate is fixed to a substrate holder and height sensors are used to measure a height-profile of the substrate. For the projected mask to become focused on the surface of the substrate during processing, the distance between the projection system and the surface of the substrate is adjusted, based on the data gathered in the measuring process.

US 6,208,407 B1 also discloses to determine prior to exposure a relation for each substrate field between an alignment mark associated with said substrate field and at least one reference mark on the substrate holder, and to use said relation for aligning the different substrate fields during exposure.

JP 02 069 958 relates to a method for easy re-inspection of a semiconductor wafer by providing a magnetic memory for storing wafer detection data on the front or rear face of a wafer support structure. That is, memory is irreversibly attached to the wafer support structure to store information, for example measurement results gathered from inspection of the wafer.

JP 2005 317 653 also relates to the problem of saving information data in association with semiconductor wafers, using basically the same techniques as JP 02 069 958.

US 2002/0127865 A1 relates to a lithography method for forming semiconductor devices with sub-micron structures on a wafer surface. The lithography method comprises the steps of coating a lithography resistor onto a wafer, exposing the wafer, stabilizing, performing a metrology inspection of the resulting lithography resistor pattern, etching, and wet processing or implanting ions. For precise exposure, a reticle is aligned with respect to the wafer by atomic force microscopy in an atomic force microscopy module, wherein the alignment marks detected by the atomic force microscopy (AFM) module are placed on the wafer itself.

The pattern on the wafer surface created by a preceding lithography process may be used for the alignment instead of alignment marks.

EP 1,617,293 A1 relates to a method of aligning a first article relative to a second article, as for example, for aligning a nano-imprint template with a semiconductor wafer. The second article is aligned with the first article using AFM-techniques and structures, wherein the makers used for alignment are placed on the articles themselves.

It is the object of the present invention to provide a concept for aligning a substrate with a process unit more efficiently, particularly in a way that allows the separation of the alignment from the processing.

This object is achieved by a method in accordance with claim 1, or by an apparatus in accordance with claims 12 and 15.

The present invention is based on the finding that a substrate can efficiently be manufactured separating the alignment and the actual processing, when an alignment mark is provided, which is fixed with respect to the substrate and when position information on a position of a process area on the substrate is retrieved with respect to the alignment mark before the substrate is actually processed. During the processing, alignment can then be performed by redetermining the position of the alignment mark and by using the stored position information.

In one embodiment of the present invention a substrate, that is to be processed, is provided together with an associated alignment mark, which is fixed with respect to the substrate. Additionally, position information on the position of process areas on the substrate is provided together with the substrate, wherein the position information is given with respect to the alignment mark (for example a two-dimensional alignment mark, that defines a coordinate system on the surface of the substrate). In other words, a substrate, that has been completely mapped, i.e. the position information of the process areas of the substrate with respect to the alignment mark is provided for a subsequent manufacturing step. The position of the one or more alignment marks on the substrate may be according to the specific implementation requirements. One choice may be to place the marks close to the border of a wafer where normally some unused space remains due to the usually rectangular geometry of devices manufactured on the substrate and the circular geometry of the wafer itself.

Therefore, during the actual processing, only a single measuring step is to be performed. Specifically, the position of the alignment mark has to be redetermined, when the substrate is inserted into the processing unit. Knowing the position of the alignment mark and having the stored position information on the process areas, the single process areas can be aligned with a process unit with high accuracy; which can for example be performed by a state of the art air-cushioned process table.

In another embodiment of the present invention, the substrate is mounted to a substrate support which that has incorporated the alignment mark. The connection between the substrate and the substrate support is such that the substrate can be removed from the substrate support without damage, such that a substrate may be used independently from the substrate support after a given production step. Using such a substrate support has the great advantage, that the substrate can be stabilized against mechanical distortions. Furthermore, the substrate can be aligned and then stored together with the substrate support, wherein the alignment (the information of the position of the process areas with respect to the alignment mark) are persistent in time. Hence, the substrate and the substrate support may even be stored or transported to another place, without using the alignment information.

It is a great advantage that the measuring (aligning) of the substrate can be separated from the processing itself, yielding a much higher overall process performance. This is of particular interest when either the processing or the aligning takes much more time than the corresponding step. Applying prior art techniques would then result in a waste of time since the sequential prior art approach would lead to unwanted wait cycles either during the processing or during the alignment.

In a further embodiment of the present invention, the alignment information is stored in a memory associated to the aligned substrate. Transferring the stored information together with the substrate is enabling a production process where the alignment is separated from the processing. In a further embodiment of the present invention, the substrate support comprises a memory device that holds the calibration information for the substrate attached to the particular substrate support.

In a further embodiment, the substrate support is having an identification mark, which is preferably machine-readable (for example a bar-code) and which is stored together with the alignment information (for example in a data base) to allow for a later association of stored alignment data with a particular substrate.

In a further embodiment of the present invention, the alignment mark is built by a nano-structured surface on either the substrate or the substrate support such that the detection of the alignment mark can be performed with an accuracy better than 10 nanometers, for example by an atomic force microscope (AFM).

In the present invention, the process unit which is used to process a substrate uses nano-imprinting techniques and provides the alignment accuracy making high-precision nano-imprinting possible.

In the present invention, the position information is received and stored as topographic information, i.e. a three-dimensional surface image of the surface of a substrate is produced within a coordinate system that is related to the position of the alignment mark. Using a topographic information rather than individual alignment marks has the great advantage that even a miss-aligned first production step would not yield a broken device, since the position information for the following production step is retrieved from the topographic information produced by the previous (possibly misaligned) production step.

Preferred embodiments of the present invention are subsequently described by referring to the enclosed drawings, wherein:
- Fig. 1: shows an example of an inventive apparatus for providing position information on a surface of a substrate;
- Fig. 2: shows a further embodiment of an inventive apparatus for providing position information;
- Fig. 3: shows an example for an inventive substrate support structure;
- Fig. 4: shows an example of an inventive apparatus for processing a substrate;
- Fig. 5: shows an example for providing position information with respect to an alignment mark;
- Fig. 6: shows an example of using provided position information;
- Fig. 7: shows an illustrative example for manufacturing a device; and
- Fig. 8: shows an illustrative example for providing position information.

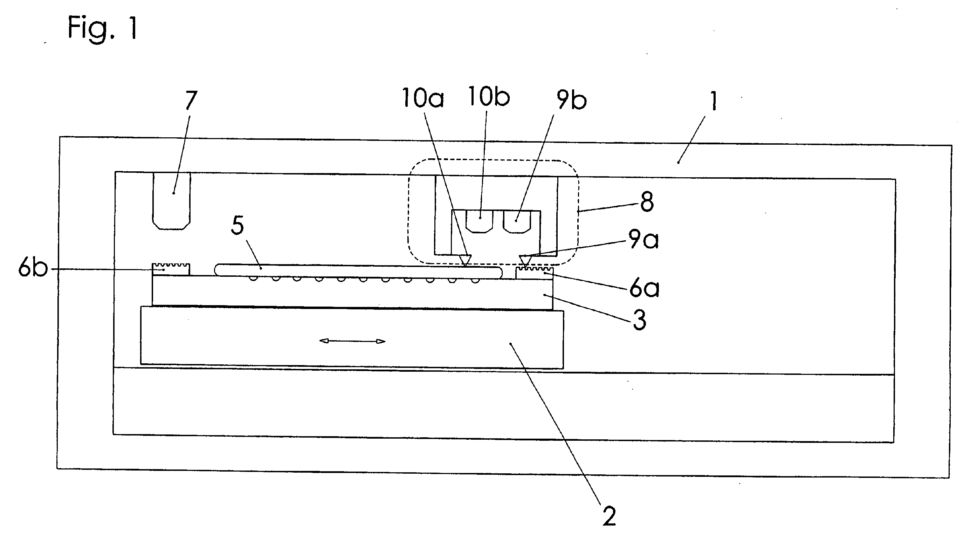

Fig. 1 shows an example of an inventive apparatus for providing position information on the position of process areas on the surface of a substrate. Fig. 1 shows a two-dimensional act of the apparatus in the direction perpendicular to the surface of the substrate. An enclosure 1 defines an enclosed process volume, which may be temperature stabilized and decoupled from the environment for allowing a precise measurement. Shown are furthermore an air-cushioned table 2, a substrate support 3, a substrate 5, a first alignment mark 6a, a second alignment mark 6b, a calibration unit 7, and a position-measuring unit 8. The substrate 5 is attached to the substrate support 3 in a reversible way, that is by means of a fixation that can be removed without damaging the substrate 5. As indicated in Fig. 1, this may for example be performed by using partly evacuated structures underneath the substrate 5 pulling the substrate to the surface of the substrate support 3. Alternatively, other ways to temporarily fix the substrate to the substrate support, which is also called temporary bonding, are of course also suited to implement the inventive concept. This can for example be achieved by "gluing" the parts together using melted wax, or by using special adhesive foils.

The substrate support 3 further comprises first and second alignment marks 6a and 6b, which are in a fixed position relative to the substrate 5. The substrate support 3 is mounted to the air-cushioned table 2, which can be moved with high precision (nanometer scale). The position-measuring unit comprises a calibration sensor 9a, an auxiliary calibration sensor 9b, a position sensor 10a, and an auxiliary position sensor 10b.

As already mentioned, the substrate 5 is fixed with respect to the first and second alignment mark 6a and 6b. To reproducibly map the surface of the substrate 5 in a fixed coordinate system, the coordinate system shall be defined by the first and the second alignment mark 6a and 6b. Therefore, the position of the alignment mark with respect to the substrate 5 has to be determined unambiguously. To achieve this, alignment mark 6a is measured by the calibration sensor 9a. In the shown example, the alignment mark 6a comprises a nano-structured surface that is probed with an atomic force microscope (the calibration sensor 9a). The calibration mark 6a is adapted to provide the position information in one dimension. Relative position measurement is possible by counting the number of bumps the atomic force microscope (calibration sensor 9a) is passing while the air-cushioned table 2 is moving. An absolute position information could then be gathered straight forwardly by counting the number of bumps from the beginning of the measurement. Alternatively the absolute position could be coded within the calibration mark 6a by varying the shape of the individual bumps or for example by having bumps of different lengths within the direction of the movement. The detection of the position of the alignment mark by probing a specific topographic structure of the surface is just one possibility. Alternative methods of measuring absolute or relative positions or distances are equivalently suited to implement the inventive concept.

To define a complete coordinate system on the surface of the substrate support 3, a second alignment mark 6b may be present on the substrate support 3, which can be detected either by a further atomic force microscope or for example by a calibration unit 7 that incorporates optical read-out, as indicated in Fig. 1. As indicated by the auxiliary calibration sensor 9b, the position of the first alignment mark 6a may also be alternatively determined by an optical read-out system. Once the alignment marks are detected and hence the coordinate system on the substrate support 3 is established, the surface of the substrate 5 can be measured by a scanning technique with respect to the established coordinate system. Having a high precision air-cushioned table 2, the scanning could for example be done by a controlled movement of table No. 2. During the stepwise movement, the position sensor 10a is able to measure the position information of the substrate 5 with high precision in the a coordinate system defined with nanometer precision and therefore allows for a later precise reproduction of the properties of the substrate.

The position information measured with the inventive apparatus is the position of previously applied topographic information on the surface of the substrate 5. The advantage is obviously that once the coordinate system on the wafer support is known and the position information is recorded in the so defined coordinate system, a processing of the wafer surface or of distinct areas of the wafer surface can be performed without individually aligning the surface areas of the wafer. On the contrary, a single determination of the position of the alignment marks 6a and 6b is enough to address every single process area on the surface of the substrate 5 (wafer).

It is one big advantage of the inventive concept that the high-precision alignment (measuring of surface criteria of the substrate 5) can be separated from processing. If either the alignment or the processing consumes much more time, this separation can yield a high gain in overall process performance. For example, a single apparatus for providing position information according to Fig. 1 may be used to align the substrates for a number of processing units.

In the inventive apparatus of Fig. 1 the position information determined is topographic information of structures previously applied to the surface of the substrate.

This has the great advantage that even in the case where a preceding processing step or even the very first processing step produced a structure on the surface of the substrate that is deviating from its design-position, a measurement of the topography of the substrate 5 will allow for a precise alignment. Such, the following processing can take place at a position yielding a fully functional device. In the prior art technique, where every processing step is aligned with imprinted alignment marks on the surface of the substrate a small misalignment of a single step of the production would lead to an unusable device and would therefore decrease the overall production efficiency.

The inventive concept provides a possibility to align structures without having to introduce special marks on the surface of a substrate. This further avoids problems with the marks themselves, which might be rendered unusable by certain processes, such as coating the whole wafer with insulating layers, which might potentially also cover the alignment marks or decrease the precision with which the alignment marks can be found by prior art optical alignment systems.

Having the fragile substrate 5 on a substrate support 3 has the additional obvious advantage that the substrate 5 can be transported without the danger of destroying the substrate 5 during the transport. Furthermore, if the topographic data is stored in a memory, which is associated to the substrate 5, the substrate support 3 can, together with the mounted substrate 5, be stored in a storage space prior to the use of the substrate 5. Then a possibility must be provided to unambiguously identify the system of substrate 5 and substrate support 3. Therefore, there are additional computer-readable marks applied to the substrate support 3, such as for example bar-codes or RFID-tokens, whose reading can be stored together with the topographic or position information in a data base. After storage, the position information can then easily be retrieved by a processing station that reads the computer-readable token and may then read the appropriate position information from a data storage.

In a further embodiment of the present invention some memory device is incorporated into the substrate support 3 such that the position information measured can be directly stored in the substrate support used to transport and store the substrate 5.

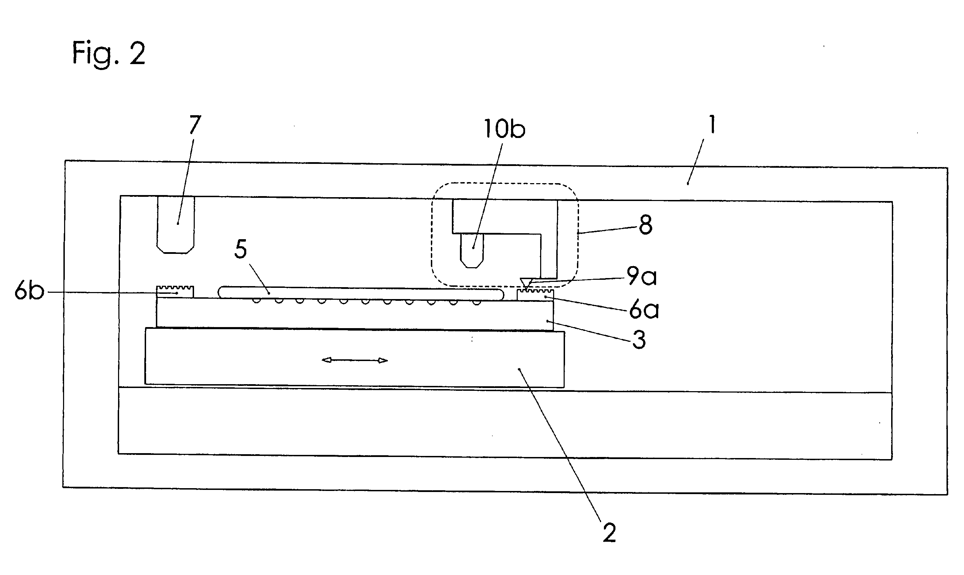

Fig. 2 shows a further embodiment of the present invention incorporating a different position-measuring unit 8, which may also serve as an example to retrieve the position information as suggested by the inventive concept.

The embodiment shown in Fig. 2 is based on Fig. 1 and therefore the identical parts are labeled with the same numbers and the description of those parts is identically exchangeable within the description of the two figures.

Fig. 2 differs from Fig. 1 in that the position-measuring unit is having an atomic force microscope as calibration sensor 9a and an optical read-out system 10b such as a confocal microscope as a position sensor to measure the surface topography of the substrate 5.

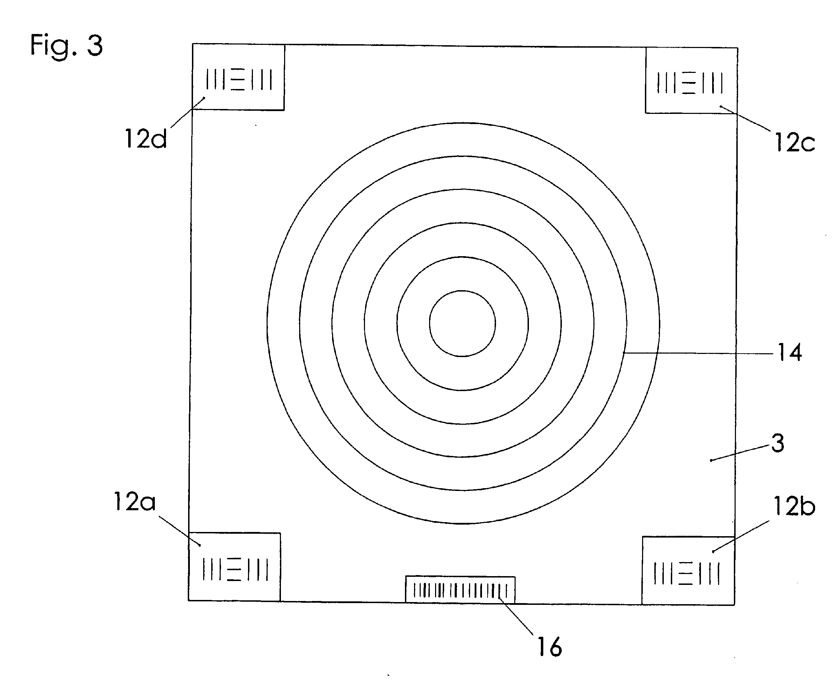

Fig. 3 shows a face on view of an example of an inventive substrate support 3.

The substrate support 3 comprises several alignment marks 12a to 12d and concentric vacuum structures 14 that may be used to fix the substrate 5 on the wafer support 3. The alignment marks 12a to 12d are shown schematically only. They are implemented as nano-structured surfaces. When an atomic force microscope is used to calibrate the position of the substrate support 3, it is also possible that the inherent surface properties of the substrate support 3 are used for the calibration without the need of applying specific calibration marks. This is possible since an atomic force microscope may probe the surface of a substrate support 3 on an atomic scale and therefore the inherent "finger print" of a specific surface area of the substrate support 3 may also be used as reference mark to calibrate the position of the substrate support 3.

The use of an inventive substrate support 3 has a number of major advantages. Evidently, a wafer and in particular a thinned wafer is protected from damage by being transported, stored, or processed when mounted to a substrate support 3. Since the substrate support 3 defines the coordinate system in which topographicinformation of the wafer surface is recorded and stored, a wafer or substrate 3 can advantageously be aligned and stored in a protected manner for later use. To allow for storage and later use of an already aligned substrate 5, the substrate support 3 also comprises an identification tag 16 that allows unambiguous identification of the specific substrate support and the wafer or substrate 5 mounted to it. As an example, the identification tag 16 is implemented to be a bar code. Alternatively, every other method of uniquely identifying the device is also possible, such as RFID-units or optical patterns. In a further preferred embodiment of the present invention the substrate support 3 further comprises a memory area in which the calibration data, i.e. the position information on the surface of the substrate 5 can be stored. This has the advantage that a database, associating specific substrates with measured information is made unnecessary, simplifying the overall handling of precalibrated substrates 5 and substrate supports 3.

When using a vacuum system as indicated by the vacuum structures 14 to fix the substrate 5 on the substrate support 3, additional structures may be incorporated into the substrate support 3 to keep the vacuum during transport or during storage. This may for example be a vacuum tank or a small vacuum pump that may be energized by an accumulator battery.

The number of alignment marks placed on the surface of the substrate support 3 is variable, a typical choice could be to place them at the four corners of the substrate support, such as shown in Fig. 3. Principally, a single alignment mark having a two-dimensional pattern that can be unambiguously identified is enough to define a coordinate system, in which the topographic information of the surface of the substrate 3 can be measured.

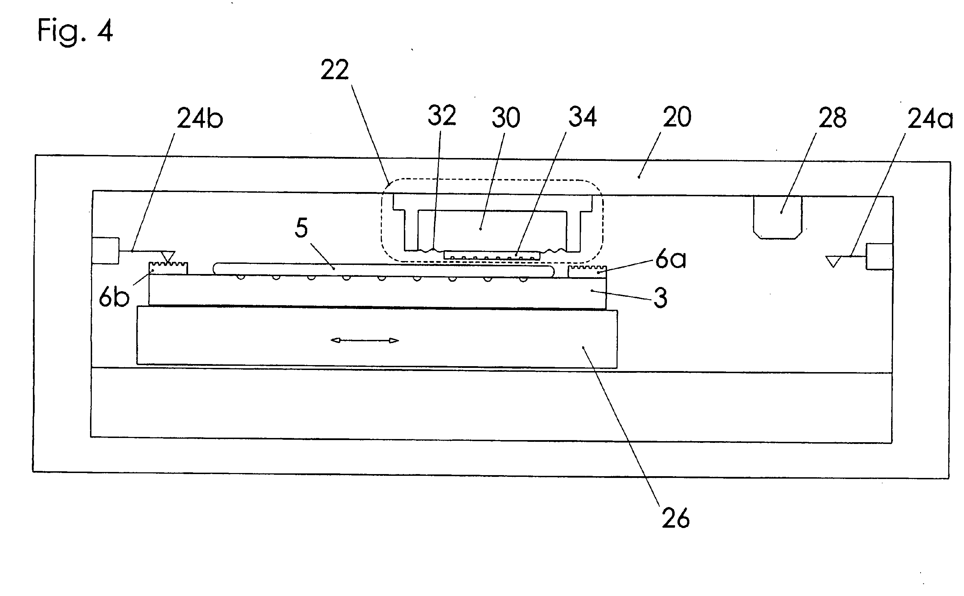

Fig. 4 shows an example of an inventive apparatus for processing a substrate. The substrate 5 to be processed is mounted on the substrate support 3 and is already calibrated (aligned), i.e. position information on the surface of the substrate 5 is available during the processing. Fig. 4 shows a housing 20 in which the active components are placed and which may be used as a vacuum chamber to have the processes in a vacuum.

Fig. 4 is further showing a process unit 22, calibration sensors 24a and 24b, an air-cushioned table 26, and an ID-reader 28. The ID-reader 28 may for example be an optical read-out system to identify the substrate support 3 by an imprinted bar code on the surface of the substrate support 3. The calibration sensors 24a and 24b are fixed with respect to the process unit 22 and are used to determine the position of the alignment marks 6a and 6b of the substrate support 3. Once the alignment marks are detected by the calibration sensors 24a and 24b, the coordinate system in which the topographic information on the surface of the substrate 5 is available, is defined. Thus, the substrate 5 can be aligned to the unit 22 with a precision in the nanometer regime, since the coordinate system is known with nanometer precision and a movement of the air-cushioned table 26 with the same precision is possible.

In the example shown, the process unit 22 comprises a vacuum volume 30, a metallic membrane 32, and a stamp unit 34. The nano-structured stamp unit 34 is adapted to print structures onto a specific process area of the surface of the substrate 5. To do the printing, a small increase of pressure is applied within the vacuum chamber 30 such that the stamp unit 34 moves down towards the surface of the substrate 5.

Using the inventive concept, it is advantageously possible to subsequently process a complete substrate surface with only having one alignment or calibration step performed using the calibration sensors 24a and 24b. Furthermore, as the process unit covers an area of the substrate 5 that is much bigger than the actual processed area given by the stamp unit 34, only the use of the inventive concept enables a production using a process unit 22 as sketched without wasting a lot of surface are of the substrate 5. This is possible according to the present invention since the structures used for the alignment are placed outside the area of the actual substrate, in contrast to prior art techniques that rely on special marks imprinted on the substrate itself.

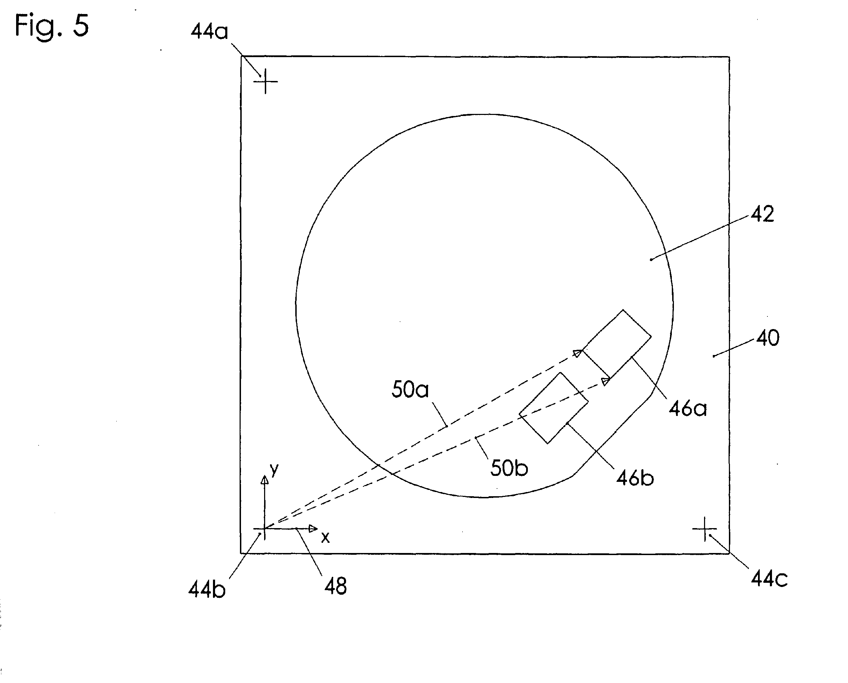

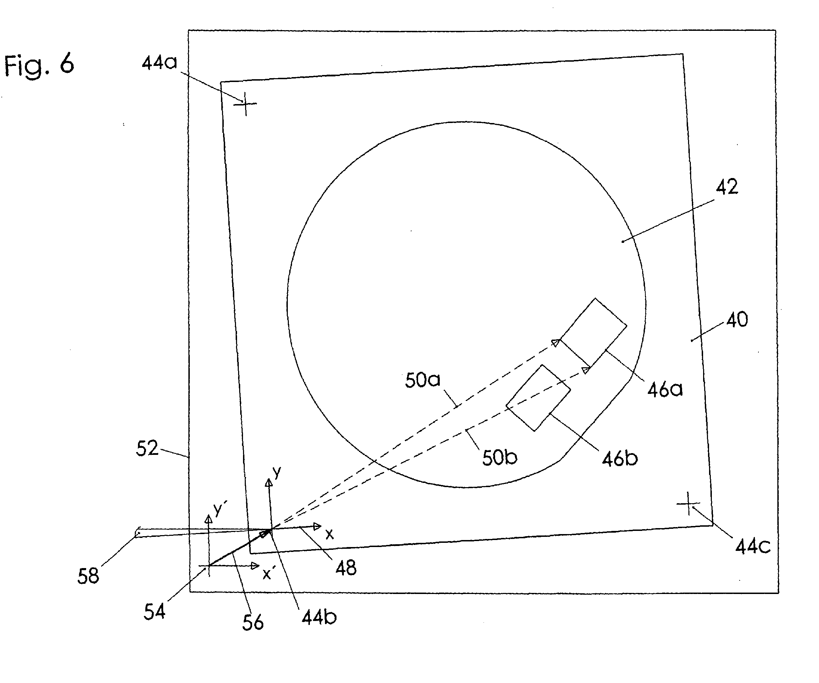

Figs. 5 and 6 illustrate, how the position information may be determined by the inventive concept and how the determined position information may later on be used during the processing in a highly efficient manner.

Fig. 5 shows a simplified scetch of a substrate support 40 with a wafer 42 mounted to the substrate support 40. In the shown example, the substrate support 40 comprises three alignment marks 44a to 44c illustrated in a simplified manner. The surface of the wafer 42 has a first process area 46a and a second process area 46b, whose positions shall be measured and stored for later processing. When the position of the alignment marks are determined, a right-handed coordinate system 48 is defined, in which the position information on the position of the first and the second process areas 46a and 46b shall be derived. This is achieved by taking a topographic image of the surface of the complete wafer 42 and identifying previously applied structures within the process areas 46a and 46b by image processing techniques. Since the topographic information is scanned within the coordinate system 48, vectors 50a and 50 b pointing for example to two edges of the process area 46a can easily be derived. In this example, the position information on the position of the process areas is stored as two-dimensional vectors in the coordinate system 48.

Fig. 6 shows the situation in an apparatus for manufacturing a device using the substrate 42 mounted on the substrate support 40. The position information provided for the manufacturing is the position vectors 50a and 50b, describing the position of the first process area 46a in the coordinate system 48 of the substrate support 40. The substrate support 40 is mechanically introduced into a process volume 52 having the process coordinate system 54, which may be used to calculate the movement of an air-cushioned table 26.

Hence the problem of alignment consists of the determination of the position information on the position of the first process area 46a in the process coordinate system 54. When determining the position of the alignment marks 44a to 44c, the coordinate system 48 of the substrate support 40 can be redetermined within the process coordinate system 54. The relative orientation of the coordinate system 48 with respect to the process coordinate system 54 can be characterized by one translation vector 56 and one rotation angle 58. Having the translation vector 56 and the rotation angle 58 determined (alignment), the position vectors 50a and 50b can easily be transformed into the process coordinate system 54. For determining the position of the first process area 46a in the process coordinate system 54, the determination of the alignment marks 44a to 44c and the knowledge of the position vectors 50a and 50b are required. Once the position of the alignment marks has been determined for the alignment of the first process area 46a, only the stored position information on the further process areas (such as the second process area 46b) is required to align those further to areas.

It may be noted that only two process areas are shown in figures 6a and 6b to simplify the drawing. However, in real implementations the wafer surface is packed with process areas as dense as possible to allow for the cheapest possible production of the single device. The inventive concept is of course applicable for any number of process areas on a substrate.

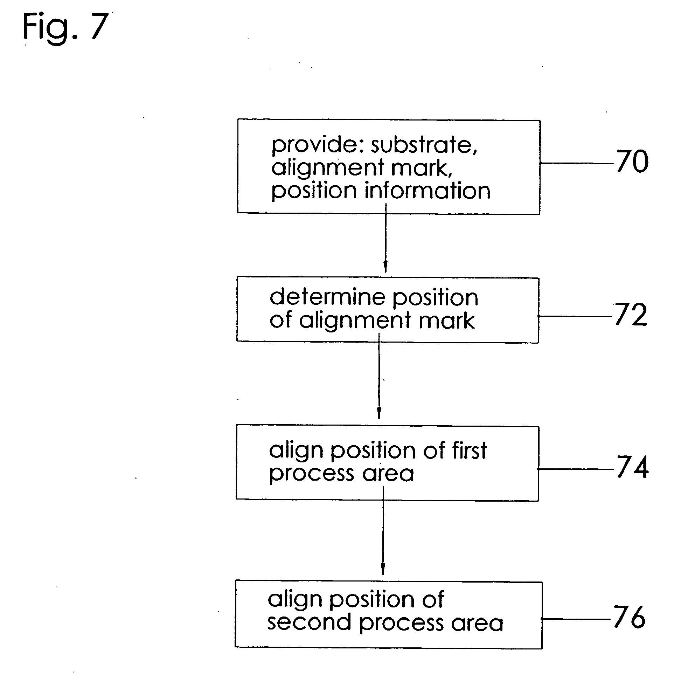

Fig. 7 illustrates an illustrative example for manufacturing a device by means of a flow-chart.

In a first providing step 70 a substrate, an associated alignment mark, which is fixed with respect to the substrate and position information on a position of a first and a second process area on a surface of the substrate is provided.

In a coordinate determination step 72, the position of the alignment mark is determined.

Then, the position of the first process area is aligned in a first alignment step 74, using information derived from the determined position of the alignment mark and from the position information on the position of the first process area provided.

Finally, in a second alignment step 76, the position of the second process area is aligned, using (information derived from the position information on the position of the second process area provided.

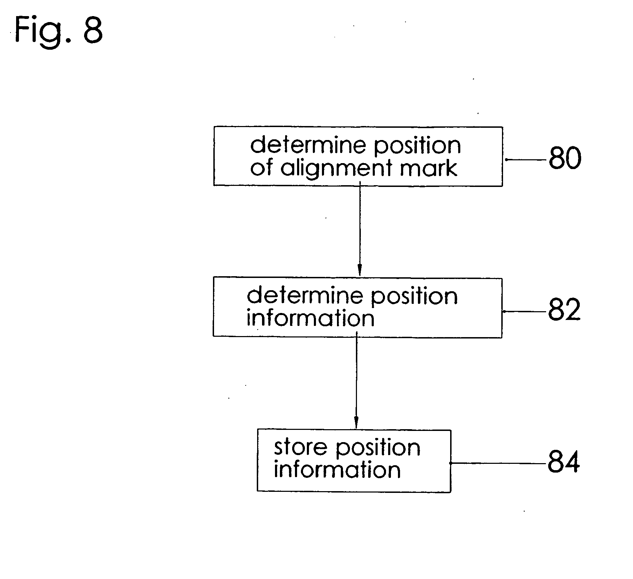

Fig. 8 illustrates an illustrative example for providing position information on a position of a first process area and on a position of a second process area on a surface of a substrate using an alignment mark, which is fixed with respect to the substrate.

In a first coordinate determination step 80, the position of the alignment mark is determined.

In a consecutive alignment step 82 position information on the position of the first process area and on the position of the second process area is determined using the position of the alignment mark.

In a storing step 84, the position information on the position of the first and on the position of the second process area is stored in association with the substrate processed.

Summarizing, the present invention suggests a substrate support, which is introduced into an apparatus for providing position information, where it may be fixed to a table that can be adjusted in the x and the y-coordinate and which can furthermore be rotated by an angle Φ. The fixing is typically performed in vacuum. On top of the adjustable table typically a measurement unit is placed, which can detect topographic information on the surface of a wafer and in particular of structures applied to this surface by different methods. Examples of methods for determining this information are confocal microscopy or raster techniques using atomic force microscopes or atomic force needles. The so determined topographic information (height coordinate), which are determined over the full area of the table are stored together with the horizontal coordinates in a storage location, such as a computer. The information can later be read-out by a separate apparatus for processing a substrate. Since the measurement of the structures and the actual processing may consume different amounts of time, it is thus advantageously possible to optimize the overall process performance (time) by combining an appropriate number of measurement and process units.

Thus, the separation of measurement and processing increases the overall process throughput. After the measurement of a structured wafer, the wafer is submitted together with the wafer support to a process unit.

A process unit consists of a table that can be adjusted in x, y, and Φ. The wafer support (wafer transport tool WTT) is fixed to that table, wherein the fixation may be performed by evacuating a volume between the wafer support and the table. The actual process unit is situated on the top of the wafer transport tool. This is a nano-stamp, which is placed in a microscopic distance above the previously created structures of the calibrated wafer. The stamp may for example be air-cushioned, that is flying on top of the wafer by the force of an air cushion, which may be created by small air injectors. Preferably, the process volume in which the processing is performed is evacuated to avoid enclosures of air on a surface of the substrate, when the surface is stamped.

The movement of the table in the process unit is computed by a control unit, which uses the position information generated in a measurement unit and the coordinates determined by probing the alignment marks on the wafer transport tool. Since topographic information of the single devices as well as the specific parameters (position of alignment marks) of the wafer transport tool have been processed during the alignment, it is possible for the process unit to precisely process the individual process areas of single devices, once the wafer transport tool has been uniquely identified by for example an identification tag. Adjusting single devices individually is thus no longer necessary during the actual processing. Furthermore, since wafer transport tools can be uniquely identified by ID-tags, one single measure-station may supply numerous process units. It is furthermore possible to combine measurement and processing into one single evacuated volume. On the other hand, it is a big advantage of the inventive concept, that the wafer transport tools may be stored in appropriate housings before being finally processed by a process unit.

Although the fixation of a substrate (wafer) on a substrate support has been previously described mainly by use of vacuum techniques, it is also possible to use any other temporal bonding technique to fix the substrate on the substrate support. This may for example be achieved by using wax, which glues together the substrate and the substrate support and which may be heated up for the removal of the substrate. Another technique known is using a foil that connects the substrate and the substrate support due to adhesive forces.

Furthermore, the geometrical shape of the substrate support is by no means restricted to be rectangular as in the above examples. It is going without saying that an inventive substrate support may have any other shape without limiting its functionality.

In the embodiments discussed in accordance with the preceding drawings, an alignment mark, which is either being placed on a substrate support or on the substrate itself is applied to the substrate or the substrate support in an orientation pointing to the surface of the substrate. It is of course possible to place the alignment mark at any other position that can be read-out by a high precision read-out such as an atomic force microscope. In particular, it may be advantageous to place the mark on the side of the substrate support that is opposite to the substrate itself, allowing for a laterally more compact implementation of the inventive concept. The alignment mark may also be placed on the backside of the substrate or the substrate support. It may be noted that it is also possible to apply the alignment mark on the surface of the substrate in the very first production step (for example by nano-imprinting) such that all following production steps align to those alignment marks.

Although an extremely high position accuracy can be achieved by use of atomic force microscopes, the use of an atomic force microscope is not mandatory to implement the inventive concept. Alternatively, any other read-out technique; for example capacitive coupling on a microscopic scale, may be used to precisely determine the position of the alignment marks.

While the foregoing has been particularly shown and described with reference to particular embodiments thereof, it will be understood by those skilled in the art that various other changes in the form and details may be made without departing from the scope thereof. The invention is defined by the appended claims.

## Claims

1. Method for manufacturing a device using a substrate (5; 42), the method comprising:
determining a position of an alignment mark (6a, 6b; 12a...d; 44a...c) being fixed with respect to the substrate (5; 42);
determining position information on the position of a first process area (46a) and on the position of a second process area (46b) with respect to the alignment mark;
redetermining the position of the alignment mark (6a, 6b; 12a...d; 44a...c);
aligning the position of the first process area (46a) using information derived from the redetermined position of the alignment mark (6a, 6b; 12a...d; 44a...c) and from the position information on the position of the first process area (46a);
processing the first process area;
aligning the second process area (46b) using information derived from the position information on the position of the second process area (46b); and
processing the second process area ;
**characterized in that** the step of
determining position information on the position of the first and second process areas comprises using topographic information determined within the process areas of the surface of the substrate (5; 42); and the step of processing the first and second process areas comprises using a nano-imprinting technique.

2. Method in accordance with claim 1, further comprising the step of: storing the determined position information on the position of the first process area (46a) and on the position of the second process area (46b).

3. Method in accordance with claims 1 or 2, further comprising the steps of:
storing or transporting the substrate (5; 42) and the alignment mark (6a, 6b; 12a...d; 44a...c) between the steps of determining the position of the alignment mark (6a, 6b; 12a...d; 44a...c) and redetermining the position of the alignment mark.

4. Method in accordance with any of the previous claims, in which the step of determining the position of the alignment mark (6a, 6b; 12a...d; 44a...c) comprises a detection of mechanical structures within the alignment mark (6a, 6b; 12a...d; 44a...c) by an atomic force microscope.

5. Method in accordance with any of the previous claims, further comprising the step of:
providing the alignment mark (6a, 6b; 12a...d; 44a...c) fixing the substrate (5; 42) to a substrate support having applied thereon the alignment mark (6a, 6b; 12a...d; 44a...c).

6. Method in accordance with claim 5, in which the fixing is performed by application of a vacuum between the substrate (5; 42) and the substrate support.

7. Method in accordance with claim 5, in which the fixing of the substrate (5; 42) to the substrate support is making use of temporal wafer bonding techniques.

8. Method in accordance with any of claims 1-4, 6, 7, further comprising the following step:
generating the alignment mark (6a, 6b; 12a...d; 44a...c) on the substrate (5; 42).

9. Method in accordance with any of the previous claims, in which the step of determining the position information on the position of the second area comprises:
determining relative position information on a relative position of the second process area (46b) with respect to the first process area (46a); and
deriving the position information on the position of the second process area (46b) using the position information on the position of the first process area (46a) and the relative position information.

10. Method in accordance with any of claims 2-9 in as for as depending on claim 2, in which additional tag information of a computer-readable information tag associated to the substrate (5; 42) is stored in the step of storing the position information, to allow for the association of the stored position information to the substrate (5; 42).

11. Method in accordance with any of the previous claims, in which the step of determining the position information on the position of the first process area (46a) and on the position of the second process area (46b) comprises:
identifying the first and the second process area (46b) by comparing the determined topographic information with stored reference-topographic information.

12. Substrate support structure adapted to allow determination of position information on a position of a process area on the surface of a substrate (5; 42), comprising:
a substrate support (3; 40) having an alignment mark (6a, 6b; 12a...d; 44a...c) ;
a substrate (5; 42), adapted to be reversibly fixed to the substrate support, such that the substrate (5; 42) is in fixed orientation with respect to the alignment mark (6a, 6b; 12a...d; 44a...c);
**characterized in that**
the alignment mark comprising a surface structure, the surface structure having topographic information; and
the substrate support structure comprising
a computer-readable information structure (16), allowing to carry information associated to the substrate (5; 42).

13. Substrate support structure in accordance with claim 12, in which information on an absolute position of the alignment mark (6a, 6b; 12a...d; 44a...c) is coded within a pattern of the surface structure of the alignment mark (6a, 6b; 12a...d; 44a...c).

14. Substrate support structure in accordance with claims 12 or 13, further comprising a memory for storing information associated to the substrate (5; 42).

15. Apparatus for processing a substrate (5; 42),the apparatus comprising:
a calibration unit adapted to determine a position of an alignment mark (6a, 6b; 12a...d; 44a...c) being fixed with respect to the substrate (5; 42);
a position measuring unit adapted to determine information of the surface of the substrate (5; 42) and to derive the position information on the position of a first process area (46a) and on the position of a second process area (46b) using information on the determined position of the alignment mark (6a, 6b; 12a...d; 44a...c) and the determined information of the surface of the substrate;
a processing device (22) adapted to process the first and the second process areas ;
a recalibration unit (24a, 24b) adapted to redetermine the position of the alignment mark (6a, 6b; 12a...d; 44a...c); and
an alignment unit adapted to perform an alignment of the processing device (22) and the first process area (46a) using information derived from the redetermined position of the alignment mark (6a, 6b; 12a...d; 44a...c) and from the position information on the position of the first process area (46a) and for performing an alignment of the processing device with the second process area (46b) using information derived from the position information on the position of the second process area (46b);
**characterized in that**
the position measuring unit is adapted to determine topographic information of the surface of the substrate (5; 42) within the process areas; and the processing device is adapted to process the first and the second process areas using nano-imprinting technique.

16. Apparatus in accordance with claim 15, in which the position-measuring unit is adapted such that the determining of the position information of the second process area (46b) comprises:
deriving a relative position information on a relative position of the second process area (46b) with respect to the position of the first process area (46a); and
deriving the position information on the position of the second process area (46b) using the position information on the position of the first process area (46a) and the relative position information.

17. Apparatus in accordance with claims 15 or 16, in which the position measuring unit is adapted to derive the position information on the position of the first process area (46a) and on the position of the second process area (46b) by identifying the first and the second process area (46b) comparing the determined topographic information with stored reference-topographic information.

## Patentansprüche

1. Verfahren zum Herstellen eines Geräts unter Verwendung eines Substrats (5; 42), wobei das Verfahren folgende Schritte aufweist:
Bestimmen einer Position einer Ausrichtungsmarke (6a, 6b; 12a...d; 44a...c), die bezüglich des Substrats (5; 42) fest ist;
Bestimmen einer Positionsinformation über die Position eines ersten Prozessbereichs (46a) und über die Position eines zweiten Prozessbereichs (46b) bezüglich der Ausrichtungsmarke;
Neubestimmen der Position der Ausrichtungsmarke (6a, 6b; 12a...d; 44a...c);
Ausrichten der Position des ersten Prozessbereichs (46a) unter Verwendung von von der neu bestimmten Position der Ausrichtungsmarke (6a, 6b; 12a...d; 44a...c) und von der Positionsinformation über die Position des ersten Prozessbereichs (46a) abgeleiteten Informationen;
Verarbeiten des ersten Prozessbereichs;
Ausrichten des zweiten Prozessbereichs (46b) unter Verwendung einer von der Positionsinformation über die Position des zweiten Prozessbereichs (46b) abgeleiteten Information; und
Verarbeiten des zweiten Prozessbereichs;
**gekennzeichnet dadurch, dass** der Schritt des Bestimmens einer Positionsinformation über die Position des ersten und zweiten Prozessbereichs ein Verwenden einer topographischen Information aufweist, die innerhalb der Prozessbereiche der Oberfläche des Substrats (5; 42) bestimmt ist; und
**dadurch**, dass der Schritt des Verarbeitens des ersten und zweiten Prozessbereichs ein Verwenden einer Nano-Einprägetechnik aufweist.

2. Verfahren gemäß Anspruch 1, das ferner folgenden Schritt aufweist:
Speichern der bestimmten Positionsinformation über die Position des ersten Prozessbereichs (46a) und über die Position des zweiten Prozessbereichs (46b).

3. Verfahren gemäß Anspruch 1 oder 2, das ferner folgende Schritte aufweist:
Speichern oder Transportieren des Substrats (5; 42) und der Ausrichtungsmarke (6a, 6b; 12a...d; 44a...c) zwischen den Schritten des Bestimmens der Position der Ausrichtungsmarke (6a, 6b; 12a...d; 44a...c) und des Neubestimmens der Position der Ausrichtungsmarke.

4. Verfahren gemäß einem der vorhergehenden Ansprüche, bei dem der Schritt des Bestimmens der Position der Ausrichtungsmarke (6a, 6b; 12a...d; 44a...c) eine Erfassung von mechanischen Strukturen innerhalb der Ausrichtungsmarke (6a, 6b; 12a...d; 44a...c) durch ein Atomkraftmikroskop aufweist.

5. Verfahren gemäß einem der vorhergehenden Ansprüche, das ferner folgenden Schritt aufweist:
Bereitstellen der Ausrichtungsmarke (6a, 6b; 12a...d; 44a...c), die das Substrat (5; 42) an einem Substratträger fixiert, an dem die Ausrichtungsmarke (6a, 6b; 12a...d; 44a...c) angebracht ist.

6. Verfahren gemäß Anspruch 5, bei dem das Fixieren durch Anbringung eines Vakuums zwischen dem Substrat (5; 42) und dem Substratträger durchgeführt wird.

7. Verfahren gemäß Anspruch 5, bei dem das Fixieren des Substrats (5; 42) an dem Substratträger zeitliche Waferkontaktierungsverfahren einsetzt.

8. Verfahren gemäß einem der Ansprüche 1 bis 4, 6, 7, das ferner den folgenden Schritt aufweist:
Erzeugen der Ausrichtungsmarke (6a, 6b; 12a...d; 44a...c) auf dem Substrat (5; 42).

9. Verfahren gemäß einem der vorhergehenden Ansprüche, bei dem der Schritt des Bestimmens der Positionsinformation über die Position des zweiten Bereichs folgende Schritte aufweist:
Bestimmen einer relativen Positionsinformation über eine relative Position des zweiten Prozessbereichs (46b) bezüglich des ersten Prozessbereich (46a); und
Ableiten der Positionsinformation über die Position des zweiten Prozessbereichs (46b) unter Verwendung der Positionsinformation über die Position des ersten Prozessbereichs (46a) und der relativen Positionsinformation.

10. Verfahren gemäß einem der Ansprüche 2 bis 9, insoweit diese von Anspruch 2 abhängen, wobei eine zusätzliche Etikettinformation eines computerlesbaren Informationsetiketts, das dem Substrat (5; 42) zugeordnet ist, in dem Schritt des Speicherns der Positionsinformation gespeichert wird, um die Zuordnung der gespeicherten Positionsinformation zu dem Substrat (5; 42) zu ermöglichen.

11. Verfahren gemäß einem der vorhergehenden Ansprüche, bei dem der Schritt des Bestimmens der Positionsinformation über die Position des ersten Prozessbereichs (46a) und über die Position des zweiten Prozessbereichs (46b) folgenden Schritt aufweist:
Identifizieren des ersten und zweiten Prozessbereichs (46b) durch Vergleichen der bestimmten topographischen Information mit einer gespeicherten topographischen Referenzinformation.

12. Substratträgerstruktur, die dahingehend angepasst ist, eine Bestimmung einer Positionsinformation über eine Position eines Prozessbereichs auf der Oberfläche eines Substrats (5; 42) zuzulassen, die folgende Merkmale aufweist:
einen Substratträger (3; 40) mit einer Ausrichtungsmarke (6a, 6b; 12a...d; 44a...c);
ein Substrat (5; 42), das dahingehend angepasst ist, reversibel an dem Substratträger fixiert zu sein, derart, dass sich das Substrat (5; 42) bezüglich der Ausrichtungsmarke (6a, 6b; 12a...d; 44a...c) in einer festen Orientierung befindet;
**gekennzeichnet dadurch, dass** die Ausrichtungsmarke eine Oberflächenstruktur aufweist, wobei die Oberflächenstruktur eine topographische Information aufweist; und
**dadurch**, dass die Substratträgerstruktur folgendes Merkmal aufweist:
eine computerlesbare Informationsstruktur (16), die es zulässt, eine dem Substrat (5; 42) zugeordnete Information zu tragen.

13. Substratträgerstruktur gemäß Anspruch 12, bei der eine Information über eine absolute Position der Ausrichtungsmarke (6a, 6b; 12a...d; 44a...c) in ein Muster der Oberflächenstruktur der Ausrichtungsmarke (6a, 6b; 12a...d; 44a...c) codiert ist.

14. Substratträgerstruktur gemäß Anspruch 12 oder 13, die ferner einen Speicher zum Speichern einer dem Substrat (5; 42) zugeordneten Information aufweist.

15. Vorrichtung zum Verarbeiten eines Substrats (5; 42), wobei die Vorrichtung folgende Merkmale aufweist:
eine Kalibriereinheit, die dahingehend angepasst ist, eine Position einer Ausrichtungsmarke (6a, 6b; 12a...d; 44a...c) zu bestimmen, die bezüglich des Substrats (5; 42) fest ist;
eine Positionsmesseinheit, die dahingehend angepasst ist, eine Information der Oberfläche des Substrats (5; 42) zu bestimmen und die Positionsinformation über die Position eines ersten Prozessbereichs (46a) und über die Position eines zweiten Prozessbereichs (46b) unter Verwendung einer Information über die bestimmte Position der Ausrichtungsmarke (6a, 6b; 12a...d; 44a...c) und die bestimmte Information der Oberfläche des Substrats abzuleiten;
ein Verarbeitungsgerät (22), das dahingehend angepasst ist, den ersten und zweiten Prozessbereich zu verarbeiten;
eine Neukalibriereinheit (24a, 24b), die dahingehend angepasst ist, die Position der Ausrichtungsmarke (6a, 6b; 12a...d; 44a...c) neu zu bestimmen; und
eine Ausrichtungseinheit, die dahingehend angepasst ist, eine Ausrichtung des Verarbeitungsgeräts (22) und des ersten Prozessbereichs (46a) unter Verwendung einer von der neu bestimmten Position der Ausrichtungsmarke (6a, 6b; 12a...d; 44a...c) und von der Positionsinformation über die Position des ersten Prozessbereichs (46a) abgeleiteten Information durchzuführen und eine Ausrichtung des Verarbeitungsgeräts mit dem zweiten Prozessbereichs (46b) unter Verwendung einer von der Positionsinformation über die Position des zweiten Prozessbereichs (46b) abgeleiteten Information durchzuführen;
**gekennzeichnet dadurch, dass** die Positionsmesseinheit dahingehend angepasst ist, eine topographische Information der Oberfläche des Substrats (5; 42) innerhalb der Prozessbereiche zu bestimmen; und
**dadurch**, dass das Verarbeitungsgerät dahingehend angepasst ist, den ersten und zweiten Prozessbereich unter Verwendung einer Nano-Einprägetechnik zu verarbeiten.

16. Vorrichtung gemäß Anspruch 15, bei der die Positionsmesseinheit derart angepasst ist, dass das Bestimmen der Positionsinformation des zweiten Prozessbereichs (46b) folgende Schritte aufweist:
Ableiten einer relativen Positionsinformation über eine relative Position des zweiten Prozessbereichs (46b) bezüglich der Position des ersten Prozessbereichs (46a); und
Ableiten der Positionsinformation über die Position des zweiten Prozessbereichs (46b) unter Verwendung der Positionsinformation über die Position des ersten Prozessbereichs (46a) und der relativen Positionsinformation.

17. Vorrichtung gemäß Anspruch 15 oder 16, bei der die Positionsmesseinheit dahingehend angepasst ist, die Positionsinformation über die Position des ersten Prozessbereichs (46a) und über die Position des zweiten Prozessbereichs (46b) durch Identifizieren des ersten und zweiten Prozessbereichs (46b), indem die bestimmte topographische Information mit einer gespeicherten topographischen Referenzinformation verglichen wird, abzuleiten.

## Revendications

1. Procédé de fabrication d'un dispositif à l'aide d'un substrat (5; 42), le procédé comprenant:
déterminer une position d'un repère d'alignement (6a, 6b; 12a ... d; 44a ... c) fixe par rapport au substrat (5; 42);
déterminer les informations de position relatives à la position d'une première zone de processus (46a) et à la position d'une deuxième zone de processus (46b) par rapport au repère d'alignement;
redéterminer la position du repère d'alignement (6a, 6b; 12a ... d; 44a ... c);
aligner la position de la première zone de processus (46a) à l'aide des informations dérivées de la position redéterminée du repère d'alignement (6a, 6b; 12a ... d; 44a ... c) et des informations de position relatives à la position de la première zone de processus (46a);
traiter la première zone de processus;
aligner la deuxième zone de processus (46b) à l'aide des informations dérivées des informations de position relatives à la position de la deuxième zone de processus (46b); et
traiter la deuxième zone de processus;
**caractérisé par le fait que** l'étape consistant à déterminer les informations de position relatives à la position des première et deuxième zones de processus comprend le fait d'utiliser les informations topographiques déterminées dans les zones de processus de la surface du substrat (5; 42); et que l'étape consistant à traiter les première et deuxième zones de processus comprend le fait d'utiliser une technique de nano-impression.

2. Procédé selon la revendication 1, comprenant par ailleurs l'étape consistant à:
mémoriser les informations de position déterminées relatives à la position du premier secteur de processus (46a) et à la position du deuxième secteur de processus (46b).

3. Procédé selon les revendications 1 ou 2, comprenant par ailleurs les étapes consistant à:
entreposer ou transporter le substrat (5 ; 42) et le repère d'alignement (6a, 6b; 12a ... d; 44a ... c) entre les étapes de détermination de la position du repère d'alignement (6a, 6b; 12a ... d; 44a ... c) et de redétermination de la position du repère d'alignement.

4. Procédé selon l'une quelconque des revendications précédentes, dans lequel l'étape de détermination de la position du repère d'alignement (6a, 6b; 12a ... d; 44a ... c) comprend une détection de structures mécaniques dans le repère d'alignement (6a, 6b; 12a ... d; 444a ... c) par un microscope à force atomique.

5. Procédé selon l'une quelconque des revendications précédentes, comprenant par ailleurs l'étape consistant à:
prévoir le repère d'alignement (6a, 6b; 12a ... d; 44a ... c) en fixant le substrat (5 ; 42) à un support de substrat présentant y appliqué le repère d'alignement (6a, 6b; 12a ... d; 44a ... c).

6. Procédé selon la revendication 5, dans lequel la fixation est effectuée par application d'un vide entre le substrat (5; 42) et le support de substrat.

7. Procédé selon la revendication 5, dans lequel la fixation du substrat (5; 42) au support de substrat utilise des techniques d'assemblage temporel de plaquettes.

8. Procédé selon l'une quelconque des revendications 1 à 4, 6, 7, comprenant par ailleurs l'étape suivante consistant à:
générer le repère d'alignement (6a, 6b; 12a ... d; 44a ... c) sur le substrat (5; 42).

9. Procédé selon l'une quelconque des revendications précédentes, dans lequel l'étape de détermination des informations de position relatives à la position de la deuxième zone comprend:
déterminer les informations de position relative relatives à une position relative de la deuxième zone de processus (46b) par rapport à la première zone de processus (46a); et
dériver les informations de position relatives à la position de la deuxième zone de processus (46b) à l'aide des informations de position relatives à la position de la première zone de processus (46a) et des informations de position relative.

10. Procédé selon l'une quelconque des revendications 2 à 9 pour autant qu'elles soit dépendante de la revendication 2, dans lequel des informations d'étiquette additionnelles d'une étiquette d'informations pouvant être lue par ordinateur associée au substrat (5; 42) sont mémorisées à l'étape de mémorisation des informations de position, pour permettre l'association des informations de position mémorisées avec le substrat (5; 42).

11. Procédé selon l'une quelconque des revendications précédentes, dans lequel l'étape de détermination des informations de position relatives à la position de la première zone de processus (46a) et à la position de la deuxième zone de processus (46b) comprend:
identifier la première et la deuxième zone de processus (46b) en comparant les informations topographiques déterminées avec les informations topographiques de référence mémorisées.

12. Structure de support de substrat adaptée pour permettre de déterminer les informations de position relatives à une position d'une zone de processus sur la surface d'un substrat (5; 42), comprenant:
un support de substrat (3; 40) présentant un repère d'alignement (6a, 6b; 12a ... d; 44a ... c);
un substrat (5; 42) adaptable pour être fixé de manière réversible au support de substrat de sorte que le substrat (5; 42) se trouve selon une orientation fixe par rapport au repère d'alignement (6a, 6b; 12a ... d; 44a ... c);
**caractérisée par le fait que**
le repère d'alignement comprend une structure de surface
la structure de surface présente des informations topographiques; et
la structure de support de substrat comprend une structure d'informations pouvant être lue par ordinateur (16), permettant de porter les informations associées au substrat (5; 42).

13. Structure de support de substrat selon la revendication 12, dans laquelle les informations relatives à une position absolue du repère d'alignement (6a, 6b; 12a ... d; 44a ... c) sont codées dans un modèle de la structure de surface du repère d'alignement (6a, 6b; 12a... d; 44a ... c).

14. Structure de support de substrat selon la revendication 12 ou 13, comprenant par ailleurs une mémoire destinée à mémoriser les informations associées au substrat (5; 42).

15. Appareil de traitement d'un substrat (5; 42), l'appareil comprenant:
une unité d'étalonnage adaptée pour déterminer une position d'un repère d'alignement (6b; 12a ... d; 44a ... c) fixe par rapport au substrat (5; 42);
une unité de mesure de position adaptée pour déterminer les informations de la surface du substrat (5; 42) et pour dériver les informations de position relatives à la position d'une première zone de processus (46a) et à la position d'une deuxième zone de processus (46b) à l'aide des informations relatives à la position déterminée du repère d'alignement (6b; 12a ... d; 44a ... c) et des informations déterminées de la surface du substrat;
un dispositif de traitement (22) adapté pour traiter les première et deuxième zones de processus;
une unité de réétalonnage (24a, 24b) adaptée pour redéterminer la position du repère d'alignement (6b; 12a ... d; 44a ... c); et
une unité d'alignement adaptée pour effectuer un alignement du dispositif de traitement (22) et de la première zone de processus (46a) à l'aide des informations dérivées de la position redéterminée du repère d'alignement (6b; 12a ... d; 44a ... c) et des informations de position relatives à la position de la première zone de processus (46a) et pour effectuer un alignement du dispositif de traitement avec la deuxième zone de processus (46b) à l'aide des informations dérivées des informations de position relatives à la position de la deuxième zone de processus (46b);
**caractérisé par le fait que**
l'unité de mesure de position est adaptée pour déterminer les informations topographiques de la surface du substrat (5; 42) dans les zones de processus; et que le dispositif de traitement est adapté pour traiter les première et deuxième zones de processus à l'aide d'une technique de nano-impression.

16. Appareil selon la revendication 15, dans lequel l'unité de mesure de position est adaptée de sorte que la détermination des informations de position de la deuxième zone de processus (46b) comprenne:
dériver une information de position relative sur une position relative de la deuxième zone de processus (46b) par rapport à la position de la première zone de processus (46a); et
dériver des informations de position relatives à la position de la deuxième zone de processus (46b) à l'aide des informations de position relatives à la position de la première zone de processus (46a) et de l'information de position relative.

17. Appareil selon la revendication 15 ou 16, dans lequel l'unité de mesure de position est adaptée pour dériver les informations de position relatives à la position de la première zone de processus (46a) et à la position de la deuxième zone de processus (46b) en identifiant la première et la deuxième zone de processus (46b) en comparant les informations topographiques déterminées avec les informations topographiques de référence mémorisées.
